Europäisches Patentamt

European Patent Office

Office européen des brevets

(11) Numéro de publication: **0 394 092**

**A1**

## (12) DEMANDE DE BREVET EUROPEEN

(21) Numéro de dépôt: **90400970.1**

(22) Date de dépôt: **10.04.90**

(51) Int. Cl.⁵: **H01L 21/338, H01L 21/28, H01L 21/033**

(30) Priorité: **21.04.89 FR 8905317**

(43) Date de publication de la demande:
**24.10.90 Bulletin 90/43**

(84) Etats contractants désignés:
**DE GB NL**

(71) Demandeur: **THOMSON COMPOSANTS MICROONDES**
**51, Esplanade du Général de Gaulle**
**F-92800 Puteaux(FR)**

(72) Inventeur: **Tung, Pham Ngu**
**Thomson-CSF, SCPI-Cédex**
**F-92045 Paris la défense(FR)**

(74) Mandataire: **Taboureau, James et al**
**THOMSON-CSF SCPI**
**F-92045 Paris La Défense Cédex 67(FR)**

(54) **Procédé de réalisation d'un transistor autoaligné.**

(57) L'invention concerne les transistors hyperfréquences : elle permet de réaliser un transistor de longueur de grille submicronique avec des moyens de masquages optiques.

Le procédé comporte une étape au cours de laquelle une résine (8), déposée sur une plaquette de matériaux semiconducteurs (1,6,16,17), est gravée en vue d'isoler un motif (9), futur masque de grille. Le masque (8 + 9) est érodé, et une couche de silice (16) déposée. En raison de l'érosion, les flancs du motif (12,13) et du masque (14,15) sont inclinés. Après gravure de la couche de silice (16) et de la résine de masquage, il reste donc deux masques de silice (18,19) dont les flancs inclinés (12,13) laissent une ouverture (21) submicronique, à travers laquelle la grille (28) est déposée.

Application à la réalisation de transistors hyperfréquences submicroniques, discrets ou intégrés.

EP 0 394 092 A1

## PROCEDE DE REALISATION D'UN TRANSISTOR AUTOALIGNE.

La présente invention concerne un procédé de réalisation d'un transistor par autoalignement de la grille et des métallisations de source et drain. Ce procédé permet d'obtenir une longueur de grille inférieure à la limite inférieure, ou pouvoir de résolution, des procédés optiques de masquage actuellement connus. Le gain obtenu dans la finesse des motifs réalisés est dû à une déformation contrôlée de l'une des couches de résine de masquage, au cours du processus d'élaboration.

Pour les transistors hyperfréquences, discrets ou en circuits intégrés, la longueur de la grille, mesurée selon la direction source-drain, est critique, dans le domaine submicronique. Les appareils de masquage optique sont les plus répandus, et d'un usage qui convient aux fabrications en grande série, mais ils ne permettent pas de masquer des grilles d'une longueur plus petite que 1 micromètre environ. Pour réaliser des transistors dits submicroniques, il faut utiliser des masqueurs électroniques qui sont beaucoup plus côuteux et surtout beaucoup plus lents, mais permettent de réaliser des grilles de 0,2 micromètre de longueur.

Le procédé selon l'invention, qui est dédié aux transistors hyperfréquences, permet de réaliser des grilles de longueurs submicroniques avec des moyens de masquage optiques, donc microniques. Il est basé sur des techniques d'autoalignement, en soi connues, mais fait intervenir un masque de résine dans lequel un motif court, à l'emplacement de la future grille, est séparé par deux courts intervalles des motifs qui masquent les futures source et drain. Les bords verticaux de ces motifs de résine sont déformés par usinage ionique ou plasma, qui leur communique un profil oblique.

Lorsqu'ensuite une couche de silice est déposée dans les intervalles, puis que les motifs de résine sont dissous, il reste dans les intervalles deux petits masques de silice qui ont des flancs obliques : l'ouverture entre ces deux petits masques est inférieure à 1 micromètre et c'est à travers cette ouverture qu'est déposée la grille, donc submicronique.

La longueur de l'ouverture est réglable par la longueur du motif central de résine et par l'usinage ionique qui a lieu ensuite : la longueur de grille est donc réglable.

De façon plus précise, l'invention concerne un procédé de réalisation d'un transistor autoaligné, comportant, supportées par un substrat et une pluralité de couches semiconductrices, trois métallisations de grille, de source et de drain, caractérisé en ce qu'il comprend au moins les étapes suivantes :
- dépôt d'une couche de résine sur le matériau semiconducteur, et masquage par des moyens optiques en vue d'isoler au moins un motif, à l'emplacement de la future grille, ce motif étant de dimensions qui sont à la limite du pouvoir de résolution des moyens optiques de masquage,
- usinage des flancs du motif et des flancs du masque de résine par gravure ionique ou plasma, en présence d'ions $O^+$, qui confère aux dits flancs un profil incliné,
- dépôt sur le masque et le motif d'une couche de silice.
- masquage de la silice par une résine, dans les intervalles entre le motif et le masque de résine, et gravure partielle de la silice, puis gravure sèche des deux masques de résine, ne laissant subsister que deux masques de silice dont les flancs inclinés laissent entre eux une ouverture de dimensions submicroniques, à travers laquelle est déposée la métallisation de grille du transistor.

L'invention sera mieux comprise par la description détaillée qui suit maintenant de deux exemples d'application, en liaison avec les figures jointes en annexes qui représentent :
- figures 1 à 9 : étapes du procédé de fabrication d'un transistor dans le cas de couches implantées,
- figures 10 à 13 : étapes du procédé dans le cas de couches epitaxiées.

Sur ces figures, les échelles sont déformées localement lorsque cela permet de les rendre plus claires.

L'invention sera exposée en s'appuyant sur l'exemple d'un transistor hyperfréquence en GaAs, à grille Schottky, mais elle est aisément transposable aux transistors à hétérojonction, ou aux transistors en silicium : ce n'est pas la structure du transistor qui importe, mais le procédé de réalisation de la métallisation de grille.

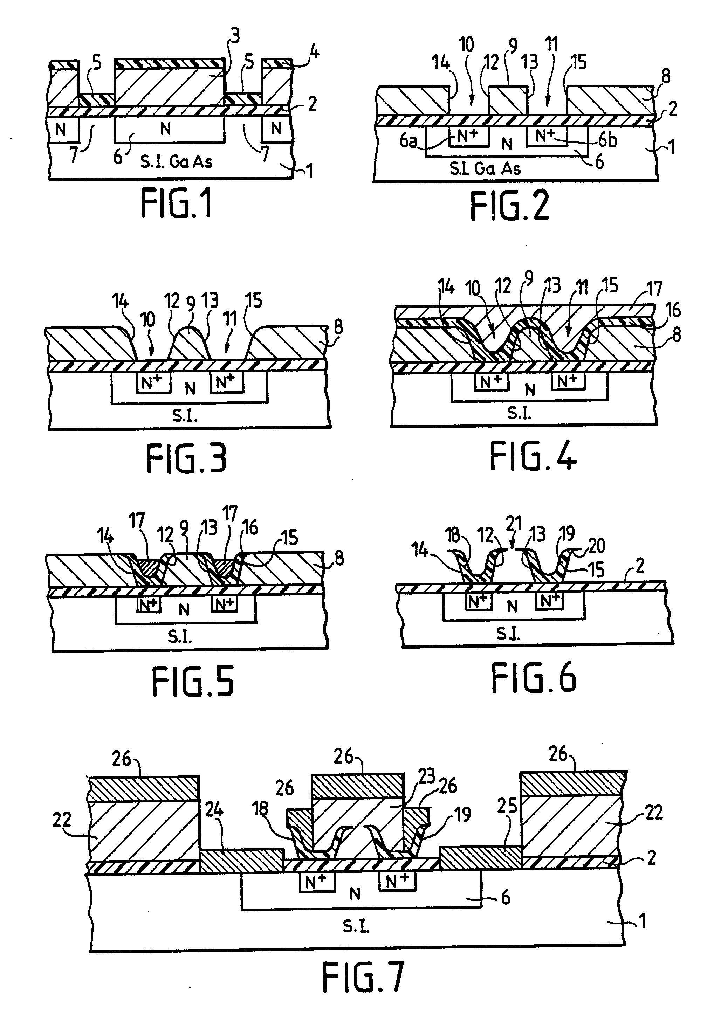

Sur la figure 1 sont superposées plusieurs étapes préliminaires du procédé, sans inconvénient pour la clarté de l'exposé, parce que ces étapes sont en soi connues.

Sur un substrat 1 de GaAs semi-isolant est déposée une couche de nitrure de silicium 2, puis un premier masque de résine qui comporte au moins un motif 3, isolé, qui correspond au transistor à réaliser. Un dépôt de silice 4 fournit un masque 5, qui entoure le motif 3 de résine. Le premier masque de résine est supprimé par dissolution, selon la technique connue sous le nom de "lift off" en anglais. Par implantation de silicium est créé au moins un caisson 6, de conductivité de type N. C'est dans ce caisson, entouré par un mur d'isolement 7 en GaAs semi-isolant, que sera créé le transistor. Le masque de silice 5 peut être retiré, et le caisson N est recuit.

En figure 2, un second masque de résine 8 est déposé sur le nitrure de silicium. Ce masque est gravé, centré par rapport au caisson 6 dans le substrat, de façon à mettre en évidence un motif 9, à l'emplacement de la future grille du transistor. Ce motif 9 est séparé du reste du masque 8 par deux intervalles 10 et 11, qui ont sensiblement les mêmes dimensions. Typiquement, le motif 9 a 1 micromètre de longueur, et les intervalles 10 et 11 chacun 1 micromètre également.

Le motif 9 a deux flancs 12 et 13, et le masque 8 a deux flancs 14 et 15 qui délimitent les intervalles 10 et 11. Tous ces flancs sont, à cette étape du procédé bien perpendiculaires au plan principal du substrat 1.

Une implantation d'ions de silicium à travers les intervalles 10 et 11 permet de créer des caissons 6a et 6b de reprises de contacts. Cette seconde implantation se fait à une dose plus élevée mais une énergie plus faible que la première implantation, de façon à ce que les caissons N$^+$ 6a et 6b ne soient pas plus profonds que le caisson N 6.

L'originalité du procédé repose sur l'opération suivante, illustrée en figure 3. Elle consiste en un usinage ou déformation du motif 9 et des flancs du masque 8 de résine, afin de rétrécir la longueur du motif 9, incliner les flancs, et arrondir les angles formés entre flancs et surface libre de la couche de résine.

Cet usinage peut se faire de deux façons :
- soit par un plasma de 0$^+$, qui rétrécit le motif 9 et arrondit les angles, mais sans incliner les flancs 12 à 15,
- soit par gravure sèche au moyen d'ions 0$^+$, selon le procédé de gravure ionique connue sous le sigle RIE (reactive ion etching, en anglais). Ce procédé est plus avantageux pour la suite des opérations, car il grave les flancs 12 à 15 de la couche de résine en leur communiquant une inclinaison ainsi que le montre la figure 3.

Le masque 8 et le motif 9 de résine, ainsi modifiés, servent de support à une seconde couche 16 de silice, d'épaisseur uniforme, déposée par pulvérisation isotrope, ainsi que montré en figure 4. Cette couche épouse les formes des deux intervalles 10 et 11.

Pour isoler dans cette couche 16 les deux petits masques de silice qui serviront à l'autoalignement, il faut d'abord rendre plane la surface externe, au moyen d'une troisième couche de résine 17 : si les intervalles 10 et 11 n'ont qu'environ 1 micromètre d'ouverture, la résine 17 les bouche, comme montré en figure 4. Si les intervalles 10 et 11 mesuraient plus de 1 micromètre, la résine 17 épouserait la forme de la couche de silice 16.

Les deux petits masques de silice sont gravés dans la couche de silice 16 par une double opération :
- par une gravure sèche, par plasma ou RIE d'oxygène, on élimine la couche de résine 17, sauf les parties qui bouchent les intervalles 10 et 11 qui sont plus épaisses,
- par une gravure sèche, par plasma ou RIE en présence de CHF$_3$ + C$_3$F$_8$, on attaque sélectivement la couche de silice 16 déposée sur la résine 8, parallèlement au plan principal du substrat 1. La silice déposée sur les flancs 12 à 15, protégée par la résine 17 qui demeure dans les intervalles 10 et 11, n'est pas attaquée.

Le résultat de cette double gravure sèche est donné en figure 5 : de la couche 16 de silice ne subsistent que deux éléments, en V, qui s'appuient sur les flancs inclinés 12 à 15 de la seconde couche de résine 8, mais sont bouchés par des restes de la troisième couche de résine 17.

Une nouvelle gravure sèche par plasma ou RIE d'oxygène débarasse la tranche de GaAs des restes de résines 8 et 16 : il ne demeure, sur la figure 6 que les deux petits masques de silice, posés sur la couche de nitrure de silicium 2. Pour simplifier la suite, on conviendra de repérer ces masques de silice 18 et 19. Puisqu'il n'y a plus de résine sur la plaquette de matériau semiconducteur, on recuit les caissons N$^+$ 6a et 6b à 850° C, pendant 20 minutes.

La forme en V desdits masques a déjà été signalée. Il faut remarquer en outre que, en raison de l'usinage ionique qui a été fait sur le second masque 8 ( fig. 3), les flancs 12 à 15 se terminent par une partie 20 arrondie, qui accentue l'effet d'ombre portée qui servira par la suite.

Il faut surtout remarquer que l'ouverture 21, entre les flancs en regard 12 et 13 des masques 18 et 19 est réglable. Si la gravure sèche du motif 9 (fig 3) est légère, le motif de résine 9 conserve une face supérieure en grande partie plane, qui fournit ultérieurement une ouverture 21 relativement grande. Si au contraire la gravure sèche du même motif 9 est prolongée, elle peut donner à l'extrême limite un motif taillé en cône, et il n'y aurait plus d'ouverture 21. Par conséquent, la dimension de l'ouverture 21 - et donc la longueur de la grille du futur transistor - est réglée par la gravure sèche du motif de résine 9, et ne dépend plus de la sophistication du matériel de masquage.

Avant d'utiliser les masques 18 et 19 pour autoaligner une grille, il faut ouvrir la couche 2 de nitrure de silicium. Pour cela, en figure 7, un quatrième masque de résine 22 est déposé sur la plaquette, puis gravé pour dégager l'emplacement des futurs contacts ohmiques de source et de drain. Un motif 23 de la couche de résine 22 doit demeurer pour boucher l'ouverture 21 entre les masques 18 et 19. La gravure de ce quatrième masque de résine ne nécessite pas une grande précision du côté des futures métallisations de source et drain, du moment que celles-ci sont en contact avec le caisson N 6, ni du côté de la future grille, qui sera définie par l'ouverture 21 : le seul impératif est que le bouchon 23 obstrue l'ouverture 21.

Ce masque étant réalisé, la couche 2 de nitrure de silicium est localement gravée, par des moyens connus, puis les contacts ohmiques en Au-Ge-Ni 24 et 25 sont déposés par pulvérisation, aux emplacements où la couche 2 de nitrure de silicium a été gravée. Au cours de la pulvérisation, le métal se dépose en 26, notamment sur le bouchon 23 et sur les bords des masques 18 et 19.

Le quatrième masque de résine 22 + 23 est alors supprimé par dissolution, selon la technique connue sous l'appellation anglaise "lift-off", ainsi que les métallisations 26 qui s'y sont déposées. De ce fait, l'ouverture 21 est libérée. Les métallisations ohmiques 24 et 25 sont recuites à 440° C.

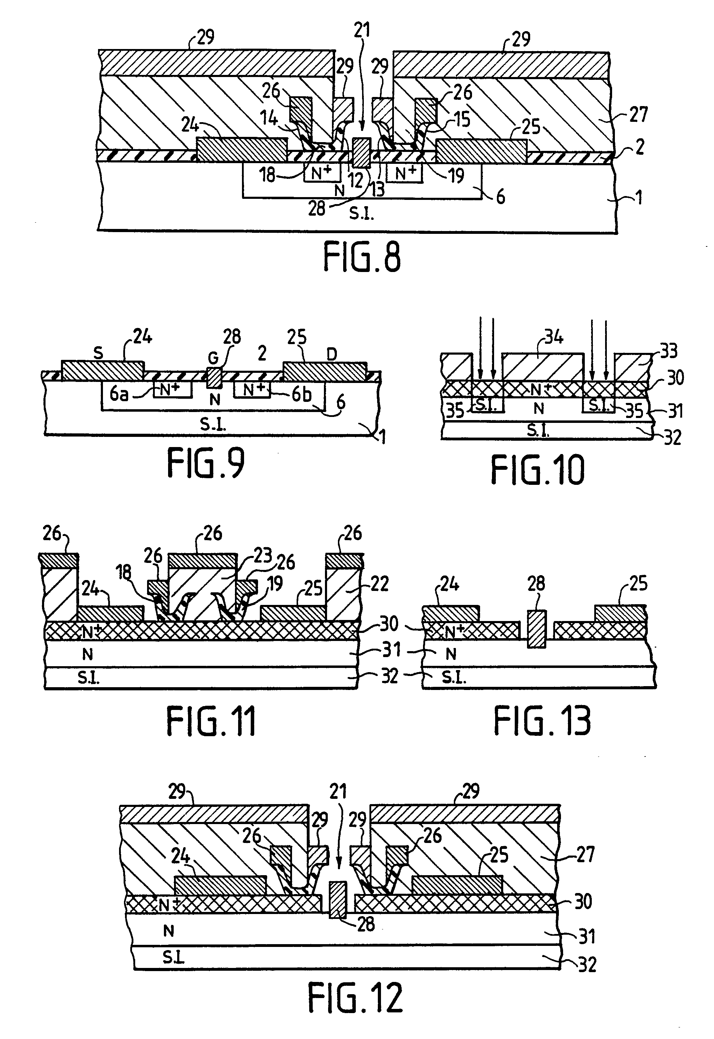

En figure 8, un cinquième masque de résine 27 est déposé, puis gravé de façon à dégager l'ouverture 21. Là encore, le masquage n'a pas besoin d'être d'une grande précision, puisque l'ouverture 21 est définie par les flancs 12 et 13 des masques de silice 18 et 19. Il suffit que la gravure dans le cinquième masque 27 soit comprise entre les flancs extrêmes 14 et 15 des masques de silice 18 et 19, en s'appuyant éventuellement sur les restes de métallisations ohmiques 26, qui n'ont pas été supprimés par "lift-off".

A travers l'ouverture 21, la couche 2 de nitrure de silicium est gravée par RIE en présence de $CHFH_3$ + $C_3 F_8$, à l'emplacement de la future grille. L'attaque est prolongée pour créer une légère dépression dans le matériau N du caisson 6, qui permet d'ajuster la tension de seuil $V_T$ du transistor.

La métallisation de grille 28 est déposée à travers l'ouverture 21, par une méthode directionnelle. Le dépôt de Ti-Pt-Au donne un contact Schottky. Au cours de cette opération, les métaux se déposent également en 29 sur le masque 27 et sur les bords des masques de silice 18 et 19.

Le cinquième masque de résine 27 et les métaux déposés sur sa surface libre sont supprimés par dissolution par "lift-off", puis les masques de silice 18 et 19, couronnés de métaux en 26 et 29 sont supprimés par dissolution dans une solution aqueuse de HF + $NH_4F$.

Le transistor achevé est présenté en figure 9 : sa structure interne, dans les couches de matériaux semiconducteurs, peut être différente de celle qui a été choisie pour exposer l'invention, et les matériaux peuvent également être différents, silicium, GaAlAs... etc, mais il a la particularité d'avoir des métallisations de grille, source et drain autoalignées, et d'avoir une longueur de grille plus petite que le pouvoir de résolution du matériel de masquage optique employé pour le second masque 8 + 9.

Les figures 10 à 13 représentent quelques étapes du procédé selon l'invention dans le cas où la plaquette de départ comporte déjà des couches épitaxiées N et $N^+$. Les autres étapes sont communes avec ce qui a été déjà exposé.

En figure 10, une plaquette de matériaux semiconducteurs comporte une couche 30 de type $N^+$ épitaxiée sur une couche 31 de type N. Un premier masque de résine 33 est gravé pour y mettre en évidence un motif 34, sous lequel sera réalisé le transistor. Une implantation de bore crée un mur d'isolement 35, semi-isolant, autour de la région masquée par le motif 34, qui correspond au masque 8 + 9 de la figure 2.

Par comparaison avec le procédé, déjà exposé :
- il n'y a pas de couche 2 de nitrure de silicium,
- il ne sera pas utile d'implanter les caissons $N^+$ 6a et 6b puisqu'une une couche $N^+$ 30 existe déjà.

La suite des opérations est identique à celle qui a été exposée en figures 2 (sans implantation de silicium) 3,4,5 et 6 pour former les masques de silice 18 et 19, mais il y a, au total, un masque de moins.

La première modification intervient au moment du dépôt des métallisations 24 et 25 de source et drain, comme représenté en figure 11, qui est à comparer avec la figure 7. Puisqu'il n'y a plus de couche 2 de nitrure de silicium, il n'est plus utile de la graver. Après dépôt et gravure du quatrième masque de résine 22 + 23 (les mêmes indices de répères qu'en figures 1-9 sont conservés), les contacts ohmiques 24 et 25 sont déposés directement sur la couche $N^+$ 30.

La seconde modification intervient au moment du dépôt de la métallisation 28 de grille : la figure 12 est à rapprocher de la figure 8. La couche 30 de matériau de type $N^+$ est gravée à travers l'ouverture 21, ainsi qu'une partie de la couche 31 de type N, de façon à ajuster la tension de seuil $V_T$. Puis la métallisation Schottky de grille 28 est déposée comme exposé plus haut au sujet de la figure 8.

Ensuite, le masque de résine 27 et les dépôts métalliques 29 sont dissous, et enfin les deux masques de silice 18 et 19 et les dépôts métalliques 26. Le transistor autoaligné obtenu par cette variante du procédé est montré en figure 13.

En résumé, le fondement du procédé selon l'invention repose sur l'utilisation de moyens de masquages optiques, qui ont l'avantage d'être plus répandus et beaucoup plus rapides que les moyens de masquages électroniques, mais sont limités physiquement à environ 1 micromètre de résolution, et sur la déformation d'un masque de résine 8 + 9, qui permet d'obtenir deux masques de silice 18 + 19, dont l'écartement est inférieur au pouvoir de résolution du moyen de masquage optique.

Bien entendu, d'autres procédés technologiques que ceux qui ont été décrits pour graver ou déposer peuvent être employés par l'homme de l'art, sans sortir du domaine de l'invention qui est définie par les revendications suivantes.

**Revendications**

1 - Procédé de réalisation d'un transistor autoaligné, comportant, supportées par un substrat (1) et une pluralité de couches de matériau semiconducteur (6,6a,6b), trois métallisations de grille (28), de source et de drain (24,25), caractérisé en ce qu'il comprend au moins les étapes suivantes :
- dépôt d'une couche de résine (8) sur le matériau semiconducteur, et masquage par des moyens optiques en vue d'isoler au moins un motif (9), à l'emplacement de la future grille, ce motif (9) étant de dimensions qui sont à la limite du pouvoir de résolution des moyens optiques de masquage,
- usinage des flancs (12,13) du motif (9) et des flancs (14,15) du masque de résine (8) par gravure ionique ou plasma, en présence d'ions $O^+$, qui confère aux dits flancs un profil incliné,
- dépôt sur le masque (8) et le motif (9) d'une couche de silice (16)
- masquage de la silice (16) par une résine (17), entre le motif (9) et le masque (8) de résine, et gravure partielle de la silice, puis gravure sèche des deux masques de résine (8,9,17), ne laissant subsister que deux masques de silice (18,19) dont les flancs inclinés (12,13) laissent entre eux une ouverture (21) de dimensions submicroniques, à travers laquelle est déposée la métallisation de grille (28) du transistor.

2 - Procédé de réalisation d'un transistor autoaligné, selon la revendication 1, à partir d'un substrat (1) en matériau semi-isolant, caractérisé en ce qu'il comporte les étapes suivantes :

a) dépôt sur le substrat (1) d'une couche de nitrure de silicium (2), premier masquage de résine (3), second masquage de silice (5), dissolution de la résine (3) et implantation de silicium pour créer un caisson (6) de type N, dissolution du masque de silice (5),

b) dépôt et masquage d'un second masque de résine (8), créant un motif de résine (9), de dimensions correspondant au pouvoir de résolution du masqueur optique utilisé, et implantation de silicium pour créer deux caissons (6a,6b) de type $N^+$ dans le caisson (6) de type N,

c) usinage des flancs (12,13) du motif (9) et des flancs (14,15) du second masque (8), par plasma d'oxygène ou gravure ionique par l'oxygène, pour rétrécir le motif de résine (9) et incliner les flancs (12,13,14,15),

d) dépôt d'une couche de silice (16) sur le second masque (8), sur le motif de résine (9) et dans les intervalles (10,11) qui séparent le motif (9) du second masque (8), et dépôt d'un troisième masque de résine (17) sur la couche de silice (16).

e) gravure sèche par l'oxygène du troisième masque de résine (17), ne laissant que la résine dans les intervalles (10,11) entre le motif (9) et le second masque (8), puis gravure sèche par $CH F_3$ + $C_3 F_8$ de la couche de silice (16), ne laissant que les deux parties (18,19) comprises entre le second (8) et le troisième (17) masques de résine,

f) gravure sèche par l'oxygène des masques (8,16) et du motif (9) de résine, laissant deux masques de silice (18,19) dont les bords inclinés (12,13) laissent entre eux une ouverture (21) de dimensions inférieures au pouvoir de résolution des moyens de masquage optique utilisés,

g) dépôt d'un quatrième masque de résine (22,23) gravure de la couche de nitrure de silicium (2) à l'emplacement des contacts de source et drain, dépôt des métallisations ohmiques (24,25) source et drain, et dissolution du quatrième masque de résine (27),

h) dépôt d'un cinquième masque de résine (27), gravure sèche par $CHF_3$ + $C_3 F_8$ de la couche de nitrure de silicium (2), à l'emplacement du contact de grille, à travers l'ouverture (21) entre les deux masques de silice (18,19), dépôt de la métallisation Schottky (28) de grille, et dissolution du cinquième masque de résine (27)

i) dissolution des deux masques de silice (18,19) dans une solution de $HF$ + $NH_4 F$ + $H_2 0$.

3 - Procédé de réalisation d'un transistor autoaligné, selon la revendication 1, à partir d'un substrat (32) comportant des couches épitaxiées de type $N(31)$ et $N^+$ (30), caractérisé en ce qu'il comporte les étapes suivantes :

a) dépôt et masquage d'un premier masque de résine (8) créant un motif de résine (9), de dimensions correspondant au pouvoir de résolution du masqueur optique utilisé,

b) usinage des flancs (12,13) du motif (9) et des flancs (14,15) du premier masque (8), par plasma d'oxygène ou gravure ionique par l'oxygène, pour rétrécir le motif de résine (9) et incliner les flancs (12,13,14,15)

c) dépôt d'une couche de silice (16) sur le premier masque (8), sur le motif de résine (9) et dans les intervalles (10,11) qui séparent le motif (9) du premier masque (8), et dépôt d'un deuxième masque de résine (17) sur la couche de silice (16)

d) gravure sèche par l'oxygène du deuxième masque de résine (17), ne laissant que la résine dans les intervalles (10,11) entre le motif (9) et le premier masque (8), puis gravure sèche par $CH F_3$ + $C_3 F_8$ de la couche de silice (16), ne laissant que les deux parties comprises entre le premier (8) et le second (17) masques de résine,

e) gravure sèche par l'oxygène des masques (8,16) et du motif (9) de résine, laissant deux masques de silice (18,19) dont les bords inclinés (12,13) laissent entre eux une ouverture (21) de dimensions inférieures au pouvoir de résolution des moyens de masquage optique utilisés,

f) dépôt d'un troisième masque de résine (22,23), dépôt des métallisations ohmiques (24,25) source et drain, et dissolution du troisième masque de résine (22,23)

g) dépôt d'un quatrième masque de résine (27), gravure sèche par $CH F_3 + C_3 F_8$ de la couche de matériau semiconducteur $N^+$ (30), à l'emplacement du contact de grille, à travers l'ouverture (21) entre les deux masques de silice (18,19), dépôt de la métallisation Schottky (28) de grille et dissolution du quatrième masque de résine (27).

h) dissolution des deux masques de silice (18,19) dans une solution de $HF + NH_4 F + H_2 O$.

4 - Procédé de réalisation d'un transistor autoaligné, selon la revendication 1, caractérisé en ce que les deux masques de silice (18,19) ont des flancs inclinés (12,13,14,15) qui sont arrondis (20) à leur extrêmité libre, cet arrondi participant à la diminution de l'ouverture (21) à travers laquelle la grille (28) est autoalignée.

5 - Procédé de réalisation d'un transistor autoaligné, selon la revendication 1, caractérisé en ce que la longueur de l'ouverture (21) est réglable par l'usinage par plasma ou gravure sèche par l'oxygène du motif de résine (9) du second masque (8).

FIG.1

FIG.2

FIG.3

FIG.4

FIG.5

FIG.6

FIG.7

FIG.8

FIG.9

FIG.10

FIG.11

FIG.13

FIG.12

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | IBM TECHNICAL DISCLOSURE BULLETIN, vol. 25, no. 3A, août 1982, pages 1189-1193, New York, US; L.M. EPHRATH et al.: "Self-aligned gate process using pattern transfer for high speed MESFET fabrication" --- | | H 01 L 21/338<br>H 01 L 21/28<br>H 01 L 21/033 |
| A | US-A-4 577 392 (PETERSON) --- | | |
| A | JOURNAL OF THE ELCTROCHEMICAL SOCIETY, vol. 133, no. 10, octobre 1986, pages 409C-416C, Manchester, NH, US; C.E. WEITZEL et al.: "A review of GaAs MESFET gate electrode fabrication technologies" ----- | | |

| DOMAINES TECHNIQUES RECHERCHES (Int. Cl.5) |
|---|
| H 01 L |

Le présent rapport a été établi pour toutes les revendications

| Lieu de la recherche | Date d'achèvement de la recherche | Examinateur |
|---|---|---|
| LA HAYE | 19-07-1990 | GELEBART Y.C.M. |